# EUROPEAN PATENT SPECIFICATION

(11) **EP 0 493 086 B1**
(45) Date of publication and mention of the grant of the patent: **21.05.1997**
(21) Application number: 91311976.4
(22) Date of filing: 23.12.1991
(51) Int. Cl.: H03M 7/46, H04N 1/417

(54) **Data decoding apparatus**
Datendekodierungsvorrichtung
Dispositif de décodage de données

(30) Priority: 24.12.1990 US 632781; 24.12.1990 US 632779
(43) Date of publication of application: 01.07.1992
(73) Proprietor: XEROX CORPORATION, Rochester New York 14644 (US)
(72) Inventor: Kao, Jean-Swey, Cerritos, California 90701 (US); Law, Simon M., Torrance, California 90504 (US); Cheung, Li-Fung, Alhambra, California 91801 (US)
(74) Representative: Johnson, Reginald George

(56) References cited:
- EP-A- 0 212 905
- US-A- 4 626 921
- US-A- 4 860 114
- PATENT ABSTRACTS OF JAPAN vol. 11, no. 81 (E-488)12 March 1987 &JP-A-61 234 664

## Description

This invention relates generally to retrieval of an electronically compressed document, and more particularly concerns a decompressor for decoding CCITT codes and supplying decompressed data to a high-speed printing engine.

US-A-4 860 114 shows a method and apparatus for expanding a two-dimensional code.

With a growing need for faster printing engines, the need for faster decompressors is also growing. A fast printing engine needs a decompressor to provide a flow of decompressed data with a speed which matches the consumption rate of decompressed data by the printing engine. If the decompressor is slower than the print engine, then a gap will be shown on the printed document.

Usually, the codes, which represent the frequent color changes on the document, slow down the decompressor. Among all the codes of CCITT two-dimensional compression algorithms, vertical codes, pass codes, and some horizontal codes can potentially generate only one-bit data. A sequence of these codes will result in worst case performance, which is the most frequent change of color. This effect slows down the flow of data to the printing engine.

To overcome the above problem, there is a great need for a decompressor capable of decompressing several or at least two codes, which can potentially generate one-bit data, in parallel. If two codes are decoded in parallel, even if both codes generate one-bit decompressed data, the output will be guaranteed to have two bits of decompressed data. This will speed up the decoding process of the CCITT two-dimensional codes.

The present invention provides an apparatus for decoding compressed image data, comprising: means for receiving and separating the compressed data image into short and long codes; short channel decoding means connected to the separating means for receiving the short codes therefrom and for generating decompressed data; said short channel decoding means includes means for receiving a first short code and a second short code from the separating means, and means for generating in parallel a first decompressed data from the first short code and a second decompressed data from the second short code; and long channel decoding means connected to the separating means for receiving the long codes therefrom and for generating decompressed data.

The invention also provides a method for decoding compressed image data, comprising: a) separating the codes into short and long codes; b) generating either a first decompressed data from a first short code or generating in parallel the first decompressed data from the first short code, and a second decompressed data from a second short code, depending on the length of the first decompressed data; and c) generating decompressed data from the long codes.

The present invention will now be described by way of example with reference to the accompanying drawings, in which:
Figure 1 is a top level block diagram of decoding apparatus of the present invention;
Figure 2 is a detailed block diagram of the code identify and alignment block 12 of Figure 1;
Figure **2A** shows the arrangement of the bits in the multiplexer (MUX) **120** of Figure **2**;
Figure **2B** is an example of the distribution of a code in the multiplexer (MUX) **120** of Figure **2**;
Figure **3** is a block diagram of code monitor **26** of Figure **1**;
Figure **4** is a detailed block diagram of the twin set decoder **36** of Figure **1**;
Figures **4A**, **4B**, **4C** and **4D** are the position of color changes on the current line with respect to the position of color changes on the previous line, for different types of codes;
Figure **5** is a detailed block diagram of the long channel decoder **28** of Figure **1**;
Figure **5A** is an example of the decompressed data for a long intermediate code;
Figure **6** is a detailed block diagram of the look-ahead logic **48** of Figure **1**;
Figure **6A** is a detailed block diagram of a position-determining block of the look-ahead logic, and
Figure **6B** is a magnified drawing of latch **446** of Figure **6**.

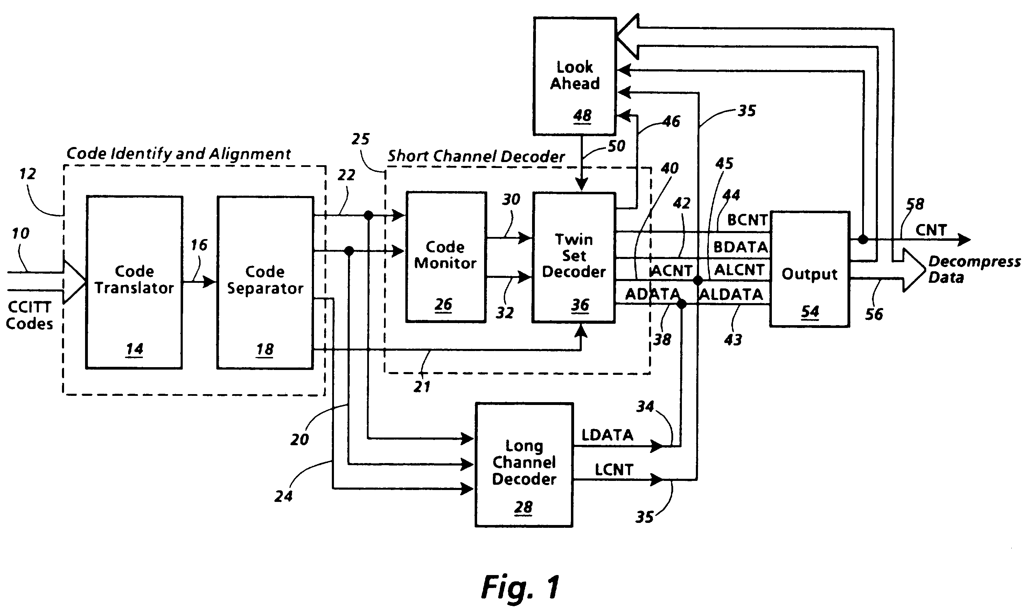

Figure **1** is a block diagram showing the implementation of the present invention. Code identify and alignment block **12** receives the variable length CCITT codes (compressed image data) from a processor interface over a 32-bit bus **10**. This block **12** comprises a code translator **14** and a code separator **18**. The code translator **14** is responsible for identifying the codes; determining the length of each code according to table 1, and aligning the next code to the most-significant bit. The code separator **18** receives the separated codes from the translator **14** over line **16** and converts the codes into intermediate format. Each block on the block diagram of Figure **1** will be described in greater detail hereinafter.

The code separator **18** divides the codes into two groups: short codes and long codes. All the codes which can produce less than four bits of decompressed data in the worst case are called short codes (vertical codes and the pass codes). Some horizontal codes produce less than four bits of decompressed data in the worst case and therefore they are also called short codes. The rest of the horizontal codes always generate more than four bits of decompressed data. These codes are called long codes. The short codes, when converted to intermediate format, are defined as short intermediate codes. The long codes, when converted to intermediate format, are defined as long intermediate codes.

The code separator **18** separates the short intermediate codes from the long intermediate codes; sends the short intermediate codes in to short channel decoder **25**, and sends the length of the decompressed data of the long intermediate codes into the long channel decoder **28**.

The short channel decoder **25** comprises a code monitor **26** and a twin set decoder **36**. The short intermediate codes can potentially generate only one-bit output data. A sequence of one-bit codes will result in worst case performance, which is the most frequent change of color. To guarantee two bits of output data per clock cycle, the twin set decoder **36** decodes two short intermediate codes in parallel. If the first short intermediate code generates more than one-bit output data, the second short intermediate code will be ignored, but if the first short intermediate code generates only one-bit decompressed data, then the decompressed data from the first short intermediate code will be sent out along with the decompressed data from the second short intermediate code.

Code monitor **26** is the interface between the code separator **18** and the twin set decoder **36**. Monitor **26** keeps track of the number of the codes that the twin set decoder **36** uses, and also aligns the incoming short intermediate codes with the unused short intermediate codes from the previous cycle.

The twin set decoder **36** sends out the data and the length of the decompressed code from the first short intermediate code on lines ADATA (A data) **38** and ACNT (A count) **40** respectively, and the data and the length of the decompressed code from the second short intermediate code on lines BDATA (B data) **42** and BCNT (B count) **44** respectively.

Long channel decoder **28** decodes the long intermediate codes and sends out the data and the length of the decompressed data on lines LDATA **34** and LCNT **35** respectively. Both the short channel decoder **25** and the long channel decoder **28** use common lines of ALDATA **43** and ALCNT **45** to send ADATA **38**, ACNT **40**, LDATA **34** and LCNT **35** to the output **54**.

With the above structure, ALDATA **43** and ALCNT **45** are dedicated to the first short intermediate codes and long intermediate codes. These two outlets are always active because at any clock cycle either the first short intermediate code or a long intermediate code is being decoded. BDATA **42** and BCNT **44** are dedicated to the second short intermediate code, and they are used only when the decompressed data from the second short intermediate code are combined with the first short intermediate code.

The look-ahead logic **48** is designed to determine the a₁b₁ and a₁b₂ distances based on the previous line (reference line) for the intermediate codes which will be decoded on the next cycle. This enables the short channel decoders to decode one/two codes for each clock cycle.

Output **54** receives the decompressed data of a long intermediate code or two short intermediate codes via lines **42**, **43**, **44** and **45**. If the code which generated the decompressed data was a long intermediate code, or a short intermediate code which generated more than one-bit data, then the output **54** receives data for only one code via ALCNT **45** and ALDATA **43**. In this case, the output sends out only one decompressed data on a 16-bit bus DATA **56**, along with a CNT (count) **58** indicating the number of valid data bits on the data bus.

The output **54** receives the decompressed data of the first and second short intermediate codes *via* ALDATA **43** and ALCNT **45**, BDATA **42** and BCNT **44** respectively, only when the first short intermediate code generates one-bit decompressed data. The output block **54** places the decompressed data of the first and second short intermediate codes back to back, and sends out the data on a 16-bit bus **56**. CNT (count) line **58** indicates how many bits on the data bus are valid data bits. In other words, CNT line **58** sends out the total length of the decompressed data.

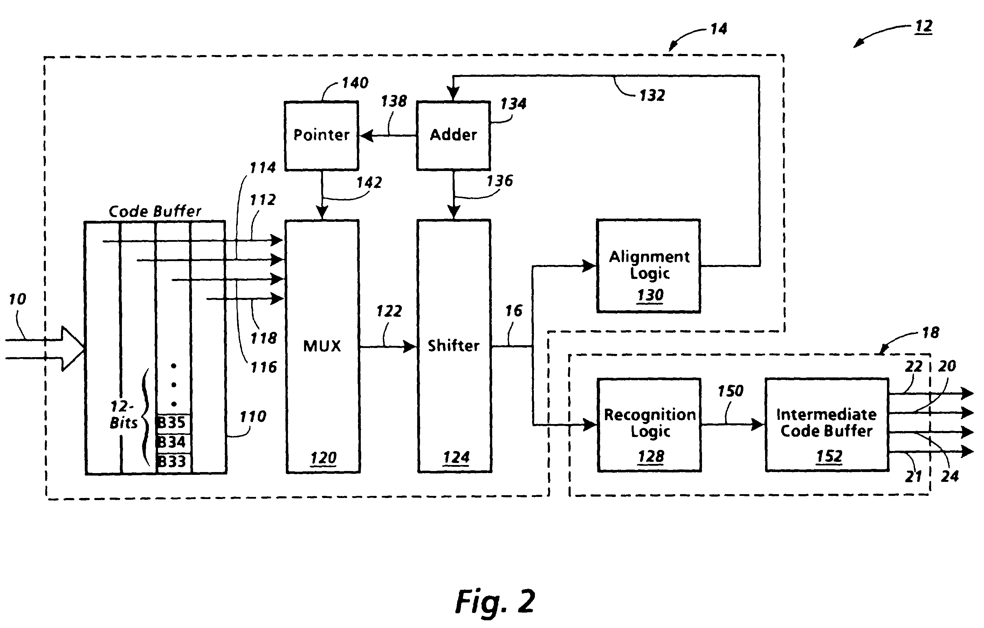

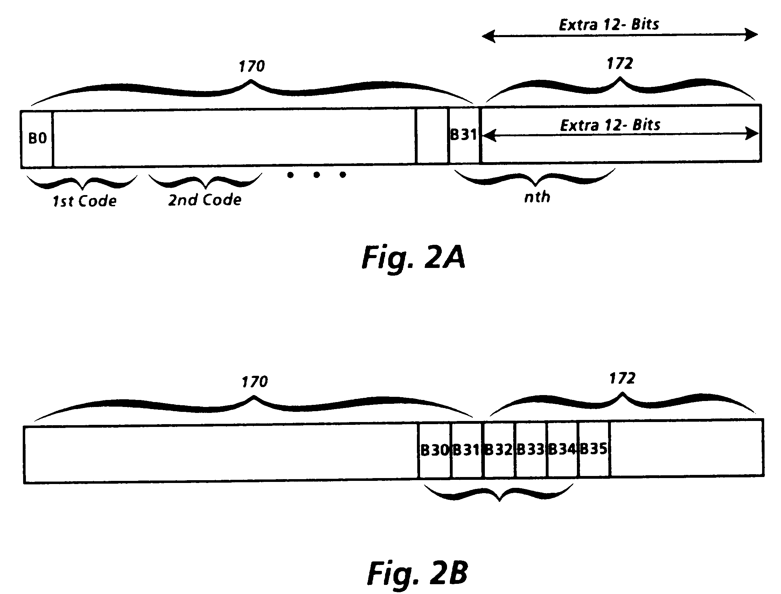

Figure **2** shows the block diagram of the code translator logic **14**. The code buffer **110** has four latches each 32-bit wide to store the incoming codes. The code buffer **110** supplies the codes through lines **112**, **114**, **116** and **118** to MUX **120**. Line **122** transfers the selection of the MUX (multiplexer) **120** to a shifter **124**. The first time the codes are transferred to shifter **124**, they will be transferred (without any shifting) to an alignment logic block **130** and to a recognition logic block **128** *via* line **16**. The alignment logic block **130** is a PLA (programmable logic array) which contains a code table. This block **130** takes two codes at a time and matches the codes against the code table to find the code lengths.

Line **132** takes the total length of two short codes or the length of a long code from alignment logic **130** to adder **134**. The adder **134** adds the received code length to the code length from the previous cycle in order to keep track of the total number of shifts. The adder 134 sends out a signal **136** notifying the shifter **124** of the number of bits to be shifted on the next cycle. Pointer **140**, which is connected to MUX **120** *via* line **142**, is controlled by adder **134** overline **138**.

MUX **120** selects one of the four latches in the code buffer block **110**. The first time MUX **120** accesses the code buffer, it retrieves 32 bits from the first latch (multiple codes) via line **118**, and 12 bits from the second latch (multiple codes) *via* line **116**. In Figure **2A** is shown the arrangement of the bits in MUX **120**. Block **170** contains 32 bits of multiple codes: the last bits of this block **170** may contain a partial code which spills over into block **172** which contains the following 12 bits of multiple codes. The extra 12 bits are retrieved into the MUX to cover maximum length for the CCITT codes (13 bits) which could spill over from the partial code of block **170**. For example, if the last bit of 32-bit **170** contains the first bit of a code, the rest of this code will be residing in **172**. If this code happens to have the maximum length of 13 bits, then the code is all covered in the last bit of **170** and the entire bits of **172**.

The shifter **124** of Figure 2 receives the codes over the line **122** and shifts out the codes two at a time. Referring to Figure 2B, the last code to be shifted out is a code that has some bits in **170** and some bits in **172**. The pointer always points to the beginning of the next code. For example, if the last code has two bits in **170** and three bits in **172**, then the pointer points to bit B35. Referring back to Figure 2, using the pointer which is pointing to bit B35, a new set of data will be transferred to the MUX **120** from the code buffer **110**. This means that a new set of 44 bits starting from bit B35 will be transferred to MUX **120** from the second and third latches *via* line **116** and line **114**.

Every time the codes are shifted, the code recognition block **128** and the code alignment block **130** receive the codes in parallel. The code recognition block **128** identifies two codes at a time and converts them into intermediate format based on Table 1 and stores them in intermediate code buffer **152** *via* line **150**.

This block **128** assigns a global intermediate format of 10000 to the pass codes, and a 00XXX intermediate format to the vertical codes in which the three least-significant bits (XXX) represent the position of a₁ with respect to b₁. For example, XXX = 111 represent VL(3) which means that a₁ is located 3 bits to the left of b₁. This block **128** also assigns a 010XX intermediate format to the horizontal leading code, and 011XX intermediate format to the horizontal tailing code. The two least-significant bits of horizontal leading code (XX) represent the relative distance between a₀ and a₁, and the two least-significant bits of horizontal tailing code (XX) represent the relative distance between a₁ and a₂. The code recognition block **128** assigns a dummy intermediate format of 11111 to the long codes.

If the recognition block **128**, at each clock cycle, identifies two consecutive short

**Table 1**

| **Code type** | | **Format** | **Position** | **XX or XXX** | **Value** |
|---|---|---|---|---|---|
| Pass code | (short) | 10000 | -- | -- | -- |
| Vertical code | (short) | 00XXX | VL(3) | 111 | -3 |
| | | | VL(2) | 110 | -2 |
| | | | VL(1) | 101 | -1 |
| | | | VL(0) | 000 | 0 |
| | | | VR(1) | 001 | 1 |
| | | | VR(2) | 010 | 2 |
| | | | VR(3) | 011 | 3 |
| Horizontal code, leading | (short) | 010XX | H(0) | 00 | 0 |
| | | | H(1) | 01 | 1 |
| | | | H(2) | 10 | 2 |
| | | | H(3) | 11 | 3 |
| Horizontal code, tailing | (short) | 011XX | 1) | 01 | 1 |
| | | | 2) | 10 | 2 |
| | | | 3) | 11 | 3 |
| Long horizontal code | (long) | 11111 | -- | -- | -- |

intermediate codes, then it sends both of the intermediate codes to the short channel decoder **25** through lines **20** and **22**. The twin set decoder block **36** decodes two short intermediate codes in parallel. If the first short intermediate code generates more than one-bit output data, the second short intermediate code will be ignored, but if the first short intermediate code generates only one-bit decompressed data, then the decompressed data from the first short intermediate code will be sent out along with the decompressed data of the second short intermediate code.

If the recognition block **128** identifies one short intermediate code followed by a long intermediate code, the short intermediate code and the long dummy intermediate code (11111) will be sent out to the short channel decoder through lines **20** and **22**. The long dummy intermediate code notifies the short channel decoder block **25** that it should decode only one short intermediate code. Therefore the short channel decoder block **25** decodes only the short intermediate code and ignores the long dummy intermediate code. On the next clock cycle, the code separator block **18** sends out the length of the decompressed data for the long intermediate code to the long channel decoder block **28** to be decoded.

At the last possibility, if the recognition block **128** identifies a long intermediate code, the recognition block **128** will send the length of the decompressed data for the long code to the long channel decoder block **28** on lines **20**, **22** and **24**. Code separator block **18** over line **21** notifies the short channel decoder block **25** that the output of the code separator block **18** is directed to the long channel decoder block **28** and therefore, the short channel decoder block **25** will be deactivated and the long channel decoder block 28 will decode the long code.

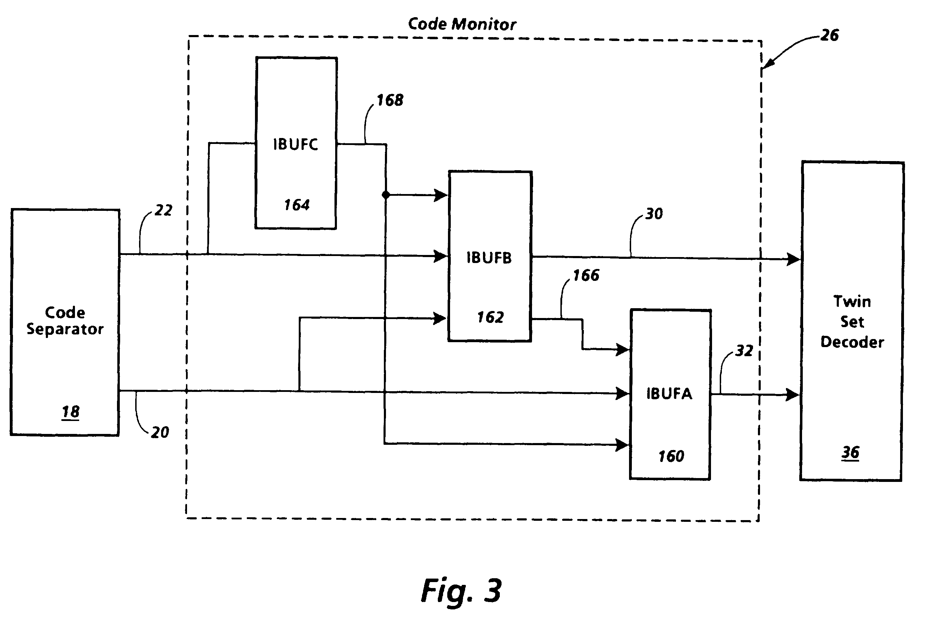

Figure **3** shows the flow of data in the code monitor **26**. This block **26** interfaces between the code separator **18** and the twin set decoder **36**. This block **26** also keeps track of the number of codes that the twin set decoder **36** uses, and aligns the incoming short intermediate codes with the unused short intermediate codes from the previous cycle. When two short intermediate codes enter the code monitor **26**, they are stored in IBUFA (intermediate code buffer A)**160** and IBUFB (intermediate code buffer B) **162** through lines **20** and **22** respectively. The twin set decoder **36** takes two intermediate codes (ICODEA and ICODEB) from IBUFA **160** and IBUFB **162** through lines **32** and **30** respectively. After the codes are decoded, if only ICODEA from IBUFA **160** is used, then the content of IBUFB **162** will be moved to IBUFA **160** *via* line **166** and the next set of short intermediate codes will be stored in IBUFB **162** and IBUFC (intermediate code buffer C )**164**. On the next cycle, the monitor block **26** sends out the content of IBUFA **160**, which is left from the previous cycle, and the content of IBUFB **162** from the current cycle to the twin set decoder as ICODEA (intermediate code A) and ICODEB (intermediate code B) respectively.

If the twin set decoder uses both short intermediate codes, then the code monitor **26** transfers the content of IBUFC **164** *via* line **168** to IBUFA **160** and directs the incoming short intermediate codes to IBUFB **162** and IBUFC **164**. If the twin set decoder uses only ICODEA from IBUFA **160**, then the code monitor **26** transfers the content of IBUFB **162** to IBUFA **160** and the content of IBUFC **164** to IBUFB **162**, and notifies the code buffer to stop sending the intermediate codes.

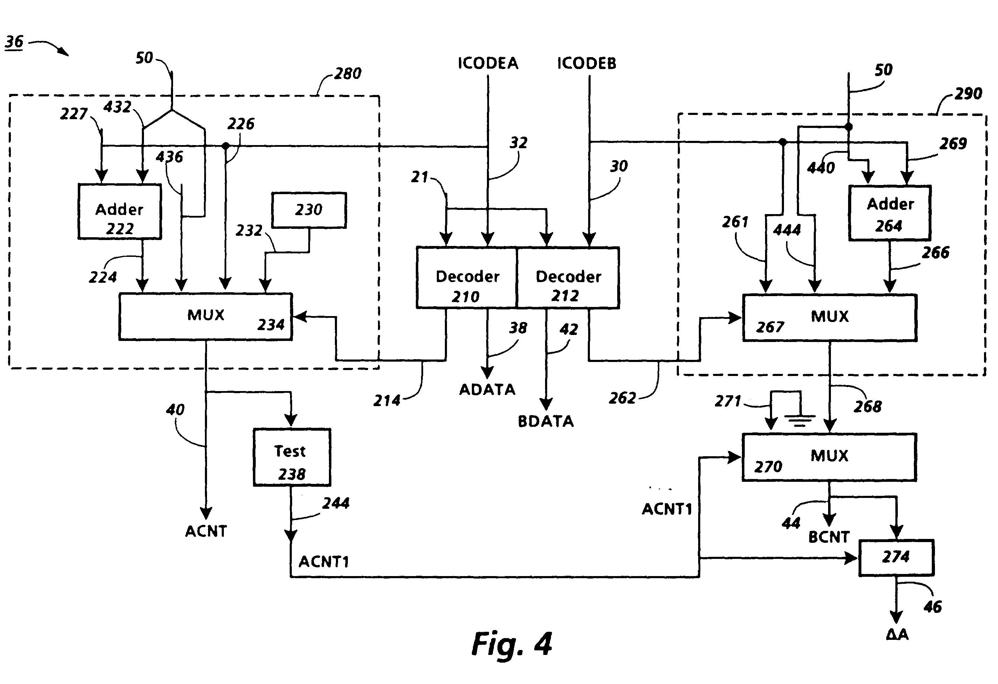

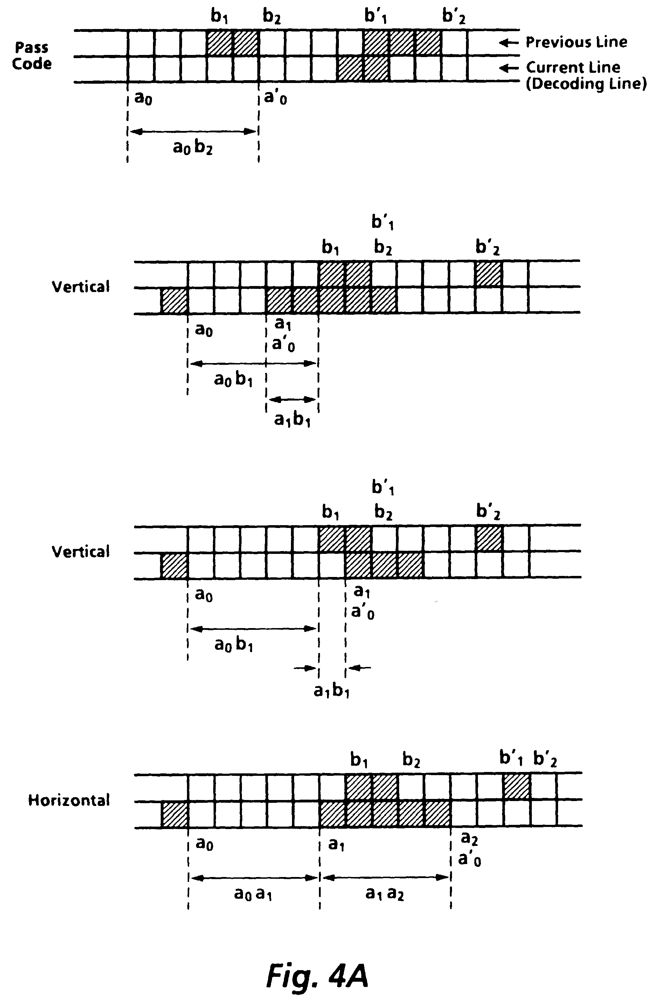

Figure **4** shows the block diagram of the twin set decoder **36**. The twin set decoder has two decoders **210** and **212**. Decoder **36** decodes two short intermediate codes in parallel and sends out the data value of the decompressed data of the first and the second short intermediate codes on ADATA **38** and BDATA **42** respectively. This block **36** also sends out the length of the decompressed data of the first and second intermediate codes on ACNT **40** and on BCNT **44** respectively. The functions of blocks **280** and **290** are to determine the lengths of the decompressed data for the first short intermediate code and the second short intermediate code respectively.

According to Table **2**, and referring to Figure **4A-D**, by having a₀b₁, a₁b₂, a₁b₁, a₀a₁ and a₁a₂ of the first short or long intermediate code, the length of the decompressed data for the first short intermediate code or the long intermediate code can be determined. The a₀b₁ is the relative distance between starting changing element on the decoding line (current line), for the first intermediate code, and the first changing element on the reference line. The a₀b₂ is the relative distance between starting changing element on the decoding line, for the first intermediate code, and the next changing element to the right of b₁ on the reference line. The a₁b₁ is determined from the three least-significant bits of the pass and vertical intermediate codes of the first intermediate code. The a₀a₁, a₁a₂ are determined from the two least-significant bits of the horizontal intermediate codes.

**Table 2**

| Code Type | Data Length |
|---|---|
| Pass code | a₀b₂ |
| Vertical code | a₀b₁ + a₁b₁ |
| Horizontal code | a₀a₁ |
| Horizontal code | a₁a₂ |

In block **280**, line **436** delivers the a₀b₂ (the length of the decompressed data for the pass code) from the look-ahead logic **48** to block **280**. The adder **222** adds a₁b₁, a₁b₁ **227**, to a₀b₁ to determine the length of the decompressed data for the vertical codes. Line a₀a₁/a₁a₂ **226** delivers a₀a₁ or a₁a₂ (the two least-significant bits of the first intermediate code) which are the lengths of the decompressed data for the horizontal leading and tailing intermediate codes.

Block **230** assigns a position for the first starting picture element for the first intermediate code on the decoding line. The information about whether a code is a pass code, vertical code or a horizontal code is delivered to MUX **234** from decoder **210** via line **214**. Based on the information on line **214**, the multiplexer **234** selects: a₀b₂ for the pass code, the result of the adder over line **224** for the vertical codes, a₀a₁, a₁a₂ over line **226** for the horizontal codes, and the output of block **230** *via* **232** for the first starting picture element of all the modes. The output **40** of MUX **234** is the length of the decompressed data for the first intermediate code.

According to Table **3**, and referring to Figure **4A-D**, by having a'₀b'₁, a'₀b'₂, a'₁b'₁, a'₀a'₁ and a'₁a'₂ for the second intermediate code, the length of the decompressed data for the second short intermediate code can be determined. The a'₀ is the starting changing element of the next code. The a'₀b'₁ is the relative distance between starting changing element on the decoding line, for the second intermediate code, and the second changing element on the reference line. The a'₀b'₂ is the relative distance between starting changing element on the decoding line, for the second intermediate code, and the next changing element to the right of b'₁ on the reference line. The a'₁b'₁ is determined from the three least-significant bits of the pass and vertical intermediate codes of the second intermediate code. The a'₀a'₁, a'₁a'₂ are determined from the two least-significant bits of the horizontal intermediate codes.

For the purpose of illustration, b'₁ will be assumed to be to the right of b₁ only, and b'₂ will be assumed to be to the right of b₂ only. Obviously b'₁ will at times be to the left of b₁, and b'₂ will at times be to the left of b₂. Also for our purposes, a'₀ is positioned only one bit after a₀, because the second intermediate code is sent out with the first intermediate code only when the first intermediate code generates one bit of decompressed data.

If the first short intermediate code generates more than one bit of decompressed data, the second intermediate code, and also all the a'₀b'₁, a'₀b'₂, a'₁b'₁, a'₀a'₁ and a'₁a'₂, will be ignored. At the next decoding cycle, the ignored second short intermediate code from the previous cycle will be decoded as the first short intermediate code using a new set of a₀b₁, a₀b₂, a₁b₁, a₀a₁ and a₁a₂.

**Table 3**

| Code Type | Data Length |
|---|---|
| Pass code | a'₀b'₂ |
| Vertical code | a'₀b'₁ + a'₁b'₁ |
| Horizontal code | a'₀a'₁ |
| Horizontal code | a'₁a'₂ |

Block **290**, which is a duplicate of block **280**, determines the length of the decompressed data for the second intermediate code. In this block **290**, line **440** delivers the a'₁b'₂ from the look-ahead logic **48**, which according to Table **3** is the length of the decompressed data for the pass code, to block **280**. The adder **264** adds a'₁b'₁, a'₁b'₁ **269**, to a'₀b'₁ to determine the length of the decompressed data for the vertical codes. Line a'₀a'₁/a'₁a'₂ **261** delivers a'₀a'₁ or a'₁a'₂ (the two least-significant bits of the second intermediate code) which are the length of the decompressed data for the horizontal leading and trailing intermediate codes.

The information about whether a code is a pass code, vertical code or a horizontal code is delivered to MUX **267** from decoder **212** *via* line **262**. Based on the information on line **262**, the multiplexer **267** selects: a'₁b'₂ over the line **444** for the pass code, the result of the adder **264** over line **266** for the vertical codes, and a'₀a'₁, a'₁a'₂ over line **261** for the horizontal codes. The output **268** of MUX **267** is the length of the decompressed data for the second short intermediate code.

Test block **238** checks the length of the decompressed data of the first short intermediate code to find out if it is one bit or more, and sends out ACNT1 **244** to MUX **270** and adder **274**. If the length of the decompressed data of the first short intermediate code is equal to one bit, then BCNT **44** (the length of the decompressed data for the second short intermediate code) will be sent out and the adder **274** adds up ACNT1 **244** and BCNT **44** to generate ΔA **46** to indicate the total length of the decompressed data for the first and second short intermediate codes. If the length of the decompressed data of the first short intermediate code is more than one bit, then MUX **270** selects zeros over line **271** to force BCNT **44** (the length of the decompressed data for the second short intermediate code) to zero. By having BCNT equal to zero, ΔA **46** will be equal to the length of the decompressed data of the first code, ACNT **40**. In this case, the second short intermediate code is ignored and the second code will be decoded as the first intermediate code on the next clock cycle.

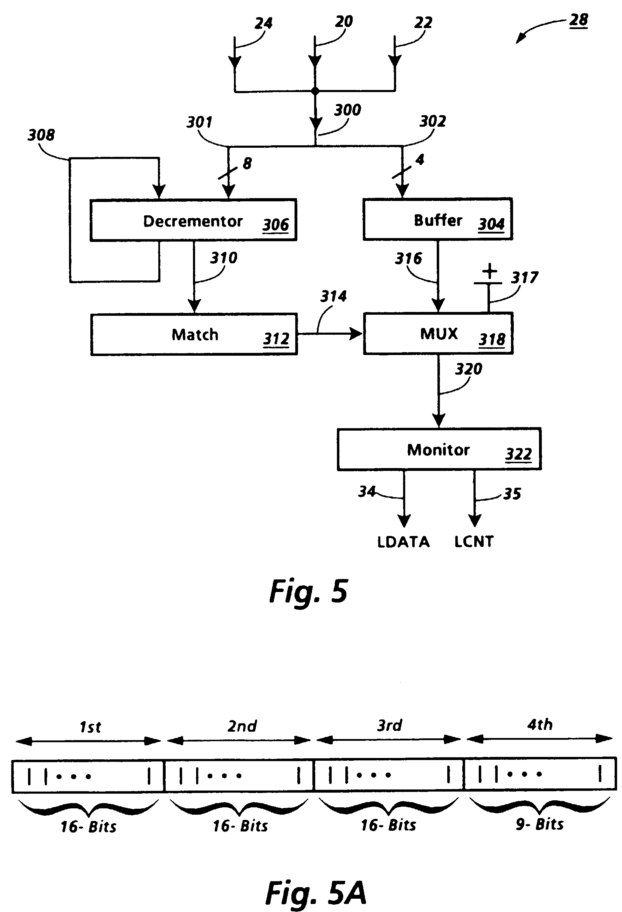

With reference to Figure **5**, long channel decoder receives the length of the decompressed data for the long intermediate codes through lines **20**, **22** and **24**. In the long channel decoder lines **20**, **22** and **24** are combined to form bus **300**. The four least-significant bits of this bus are directed to buffer **304** through line **302**. The eight most-significant bits of this bus are directed to the decrementor **306** through line **301**. Line **308** is the feedback line of the decrementor block **306**. The reason for splitting the bits is that if the eight most-significant bits are equal to zero, then the length of the decompressed data is less than 16 and it is represented by the four least-significant bits which are stored in buffer **304**. If the value received by the decrementor **306** is more than zero then the length of the decompressed data code is longer than 16 bits.

The matching block checks the output **310** of the decrementor **306** to determine whether the content of the decrementor is equal to zero. When the content of the decrementor is more than zero, the match block **312** sends a signal **314** to MUX **318** for selecting line **317** to output a length of 16. At this time, the decrementor will be decremented by one. This process will be repeated until the content of the decrementor **306** will become zero. When the value of the decrementor is zero, then the match block sends a signal **314** to MUX **318** for selecting line **316** to let the content of buffer **304** go out.

The monitor block **322** monitors the change of color from one code to the next code. For example, if the color of the decompressed data of the last code before the long code was black (data= 1) and the last code before the long code was not a pass code, then the color of the decompressed data of the long code will be white (data=0). The monitor block **322** also receives the length of the decompressed data from MUX **318** *via* line **320** and sends out the length on LCNT **35** and the data on LDATA **34**.

An example can clarify the process. Referring to Figure **5** and **5A**, if the length of the decompressed data of a long intermediate code entering the long channel decoder is 00000011 1001, then 1001 will be stored in the buffer **304** and 00000011 will be delivered to the decrementor **306**. The decrementor needs to be decremented three times to reach zero. By each decrement an LCNT= 16 is sent out. On the 4th cycle the decrementor **306** is equal to zero, therefore a LCNT= 9, which was held in the buffer as (1001), will be sent out. If the monitor block determines that the LDATA for this long code is one, then for three cycles 16 ones in the form of LDATA=1 and LCNT=16 (16 bits) will be sent out, and on the fourth cycle nine ones in the form of LDATA = 1 and LCNT = 9 will be sent out.

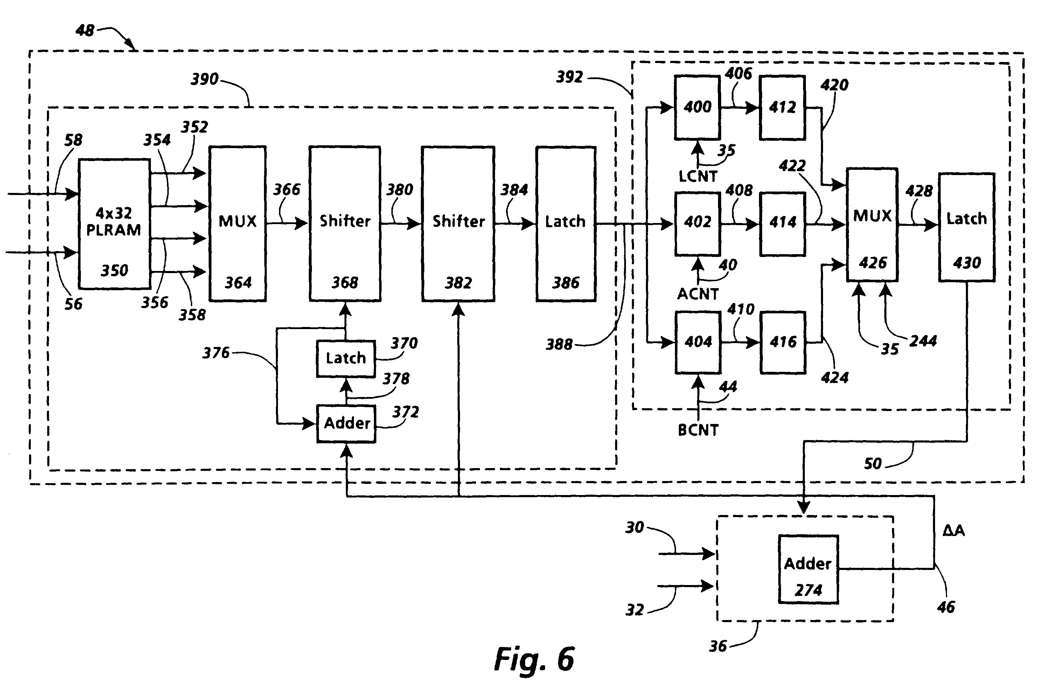

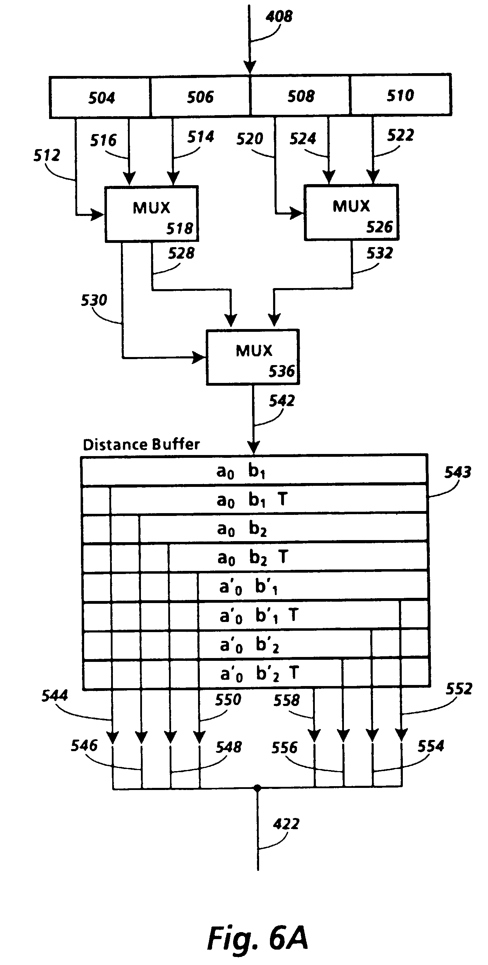

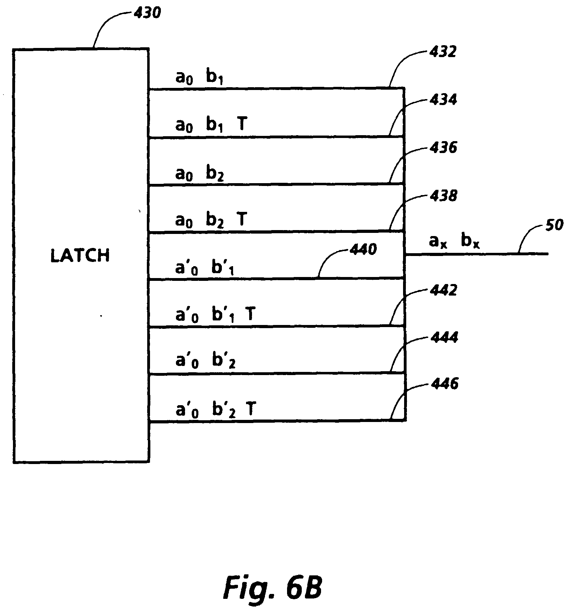

Figure **6** shows the block diagram of the look-ahead logic. This block **48** is used to speed up the process of decoding by determining the positions of b0 and b₁ for the first and second next intermediate codes (the codes to be decoded on the next decoding cycle) while the current code (the code in the process of decoding) is being decoded. Using this logic, every clock cycle can be used for decoding a code *versus* not using the look-ahead logic, which requires two clock cycles for decoding a code.

Without the look-ahead logic, the decoding process is a slow process because one clock cycle is dedicated to decoding the code and determining the length of the decompressed data, and the next clock cycle is dedicated to determining the position of the next a₀, b₁ and b₂. While determining the position of the next a₀ , b₁ and b₂, the next code cannot be decoded, because a₀, b₁ and b₂ have to be present for decoding the next code.

Referring to Figures **4A-4D**, the look-ahead block **48** determines the position of b₁ (the first changing element on the reference line to the right of a₀ and of opposite color to a₀) and the position of b₂ (the next changing element to the right of b₁ on the reference line) for the next first short or long intermediate codes. This block **48** also determines the positions of b₁ and b₂ for the second next short intermediate code. Block **390** is responsible for retrieving the previous line decompressed data and shifting it to align the bits of the previous line with the bits on the decoding line. Block **392** is responsible for determining the b₁, b₂, b'₁ and b'₂ positions.

Previous line PLRAM **350** receives the decompressed data from the output block **54** over DATA **56** and CNT **58**. As the decompressed data are sent out from the output block **54**, the PLRAM **350** stores the decompressed data. When the decoding of the decoding line is completed, the PLRAM **350** contains the decompressed data of the entire decoding line, which will be considered a reference line for the next decoding line.

Lines **352**, **354**, **356** and **358** transfer the data from the PLRAM **350** to MUX **364** in the same manner as data transfer from code buffer **110** to MUX **120** in Figure **2**. Line **366** takes the data to the first shifter **368**. The shifted data will be sent to the second shifter **382** *via* line **380**. The reason to have two shifters is that accessing the RAM **350**, and shifting the data to update the previous line decompressed data with the current line position, cannot be done in one cycle.

ΔA **46**, which is connected to shifter **382** and the adder **372**, carries the total number of bits by which the decoding line is advanced on each cycle. The adder **372** adds up all the incoming ΔA's to keep track of total number of advancement on the decoding line. The output of adder **372** will be transferred to the latch **370** over line **378**. Shifter **368** uses line **376**, the output of the latch **370**, to shift the data, thus updating the previous line decompressed data to the a₀ position of the current intermediate code data at the end of the previous cycle. Line **376** is also used as a feedback to the adder **372**.

Shifter **382** receives the previous line data from shifter **368** through line **366** and uses ΔA **46** to shift the data, thus updating the previous line decompressed data to the a₀ position of the next intermediate code at the end of the current cycle. The updated data are stored in latch **386** *via* line **384** and, at the beginning of the next clock cycle, the stored data will be transferred to block **392** *via* line **388**.

At the edge of each clock cycle, block **392** receives 36 bits of previous line decompressed data *via* a 32-bit line **388**. The received data will be transferred to shifters **400**, **402** and **404** in parallel. Block **392** is responsible for finding the a₀b₁, a₀b₂ for the first next intermediate code, and a'₀b'₁ and a'₀b'₂ for the second next intermediate code, regardless of the different possibilities of the current intermediate codes and the different possibilities of the next codes.

In order to find the a₀b₁, a₀b₂, a'₀b'₁ and a'₀b'₂ for the next two codes, block 392 has to shift the previous line data to the next a₀. For shifting the previous line data to the next a₀, the length of the current intermediate code has to be determined. While the current intermediate code is in the process of decoding, the a₀b₁, a₀b₂, a'₀b'₁ and a'₀b'₂ from the previous cycle, and the information available from the format of the intermediate codes, can be used to determine the length of the data.

Block **402** shifts the data, assuming that the first current short intermediate code generates more than one bit decompressed data. This block **402** uses ACNT (the length of the first intermediate code) as a shift signal.

Block **404** shifts the data, assuming that the first current short intermediate code generates only one bit decompressed data. Therefore, one bit will be added to the length (BCNT) of the decompressed data of the second current short intermediate code to determine the total length of the decompressed data for the current code. This block **404** receives BCNT **44** and adds 1 to the BCNT **44** and uses 1 + BCNT (the total length of the first and second short intermediate codes) as a shift signal.

For a long code, the length of the decompressed data could be equal to multiples of 16 bits. For example, if the length is equal to 62, then for three clock cycles the previous line will be shifted by 16 and on the fourth cycle the previous line will be shifted by 14 bits. Therefore, block **400** uses LCNT **35** as the shift signal.

Blocks **412**, **414** and **416** receive the shifted previous line decompressed data from the shifters **400**, **402** and **404** *via* lines **406**, **408** and **410** respectively. Each one of these blocks **412**, **414** and **416** generates a set of a₀b₁, a₀b₂, a'₀b'₁ and a'₀b'₂ for the next two intermediate codes, depending on the current intermediate codes in the process of decoding.

Blocks **412**, **414** and **416** each independently finds the b0, b₁, b'0 and b'₁ positions for the next two intermediate codes to be processed, and each generates a set of a₀b₁, a₀b₂, a'₀b'₁ and a'₀b'₂ based on one of the three different possibilities of the current codes. Block **412** generates the above information based on the assumption that the current code in the process of decoding is a long intermediate code. Block **414** generates the above information based on the assumption that the current codes in the process of decoding are two short intermediate codes and the first intermediate code generates more than one bit data. Block **416** generates the above information based on the assumption that the current intermediate codes in the process of decoding are two short intermediate codes and the first short intermediate code generates only one bit decompressed data which will be combined with the decompressed data of the second short intermediate code.

At the end of the decoding cycle, if the current intermediate code in the process of decoding is a long intermediate code, then the output **420** of block **412** will be selected. If the codes in the process of decoding are two short intermediate codes and the first short intermediate code has more than one bit, then the output **422** of block **414** will be selected. If the intermediate codes in the process of decoding are two short intermediate codes, and the first short intermediate code has only one bit, then the output **424** of block **416** will be selected.

Blocks **412**, **414** and **416** receive the previous line decompressed data, which are already shifted to the a₀ position of the next intermediate code, *via* lines **406**, **408** and **410**. Figure **6A** shows a detailed block diagram of blocks **414**. Blocks **412** and **416** are identical to block **414**, but for the purpose of clarity only block **414** is shown on Figure **6A**. Blocks **504**, **506**, **508** and **510** divide the received data into four nibbles, with each block containing a nibble. Each one of these blocks checks its respective nibble to find a change in data. Each change has a defined a₀b₁ and a₀b₂ on a look-up table.

If there is a change in the first nibble, then block **504** sends out a₀b₁. If the second change happens to be on the second nibble, then block **506** sends out a₀b₂ and the rest of the nibbles are ignored. If there are two changes at the first nibble, both a₀b₁ and a₀b₂ will be sent out from block **504** and the rest of the nibbles will be ignored. If no change is detected on any of the nibbles, then a₀b₁T, a₀b₂T, a'₀b'₁T and a'₀b'₂T will be sent out to flag the continuation of the long code to the next decoding cycle.

The outputs of blocks **504** and **506** are transferred to MUX **518** *via* lines **516** and **514**. Line **512** is the select line for MUX **518**. If there is a change on the first nibble, MUX **518** selects line **516**, and if there is no change on the first nibble then the control line **512** toggles to select line **514**. Mux **526**, which has the same function as MUX **518**, selects the outputs of blocks **508** or **510** *via* lines **524** or **522** respectively. Line **520** is the select line for MUX **526**. MUX **536**, with line **530** as the select line, selects the outputs of MUX **518** or MUX **526** *via* lines **528** or **532** respectively and sends out the result on line **542**.

The same procedure has to be repeated for determining a'₀b'₁ and a'₀b'₂, except the shifters **400**, **402** and **404** have to shift the data by one bit and then send the data to blocks **504**, **506**, **508** and **510**. One-bit shifting is done because the difference between a'₀ and a₀ is only one bit. The a'₀ is the a₀ for the second intermediate code, and the second intermediate code will be used only if the first code generates one bit.

MUX **536** sends out a₀b₁, a₀b₁T, a₀b₂, a₀b₂T, a'₀b'₁, a'₀b'₁T, a'₀b'₂ and a'₀b'₂T to be stored in distance buffer **543** overline **542**. Lines **544**, **546**, **548**, **550**, **552**, **554**, **556** and **558** transfer a₀b₁, a₀b₂, a'₀b'₁ and a'₀b'₂ respectively to MUX **426**. For simplicity, all the outputs of distance buffer **543** are shown as line **422**.

Referring back to Figure **6**, MUX **426** receives three sets of data based on three different assumptions and selects one set. At the end of the decoding cycle, if the current intermediate code in the process of decoding is a long code, then the select signal LCNT **35** of MUX **426** selects the output **420** of block **412**. If the codes in the process of decoding are two short intermediate codes, and the first short intermediate code has more than one bit, then the select signal ACNT1 **244** ( equal to 0) of MUX **426** selects output **422** of block **414**. If the codes in the process of decoding are two short intermediate codes and the first short intermediate code has only one bit, then the select signal ACNT1 **244** ( equal to 1) of MUX **426** selects output **424** of block **416**. MUX **426** sends out the selected set of data *via* line **428** to be stored in latch **430**.

Referring to Figure **6B**, lines **432**, **434**, **436**, **438**, **440**, **442**, **444**, and **446** transfer a₀b₁, a₀b₁T, a₀b₂, a₀b₂T, a'₀b'₁, a'₀b'₁T, a'₀b'₂ and a'₀b'₂T respectively from latch **430** to the twin set decoder **36**. For simplicity, all the outputs of latch **430** are shown as line **50**.

As an alternative to the described embodiment, blocks **400** and **412** of Figure **6** can be eliminated and blocks **402** and **414** can take over the function of blocks **400** and **412**. This structure also can handle the occurrence of the three different possibilities of: two short intermediate codes; a long intermediate code followed by a short or long intermediate code, and a short intermediate code followed by a long intermediate code. If the current codes happen to be two short intermediate codes, blocks **402**, **414**, **404** and **416** perform their functions as described above. If the current codes happen to be a long intermediate code followed by a short or long intermediate code, again blocks **402**, **414**, **404** and **416** perform their functions as described above. In this case, since the long intermediate codes always generate more than four bits of data, MUX **426** always selects the output **422** of the block **414**.

If the current codes happen to be a short intermediate code followed by a long intermediate code, then MUX **426** can be designed in two ways. First, MUX **426** also receives the long dummy intermediate code. Every time there is a long dummy intermediate code, MUX **426** automatically selects the output **422** of block **414** regardless of first short intermediate code generating one or more bits. Second, MUX **426** selects the output **424** of block **416** just as was described above. In this case, if the first short intermediate code generates one bit data, the dummy long code does not generate any decompressed data (BCNT = 0), which makes the BCNT + 1 ( shift signal of block **404**) equal to 1. Therefore, both blocks **402** and **404** shift the decompressed data of the previous line by one bit, and blocks **414** and **416** generate identical information. Even though in this case there is no second intermediate short code, if the first intermediate code generates one bit decompressed data, MUX **426** selects the output **424** of the block **416** which has the same correct information as output **422** of block **414**.

Referring back to Figure **6**, interrelated functions of short channel decoder **25** with look-ahead block **48** can be described in more detail. At the beginning of each clock cycle, if the short channel decoder **25** is used, two short intermediate codes will enter both the short channel decoder **25** and block **392** of the look-ahead logic **48**. Also the previous line decompressed data, updated for the current cycle **388**, will enter block **392**, while aₓbₓ **50** for the first and second short intermediate codes will enter the twin set decoder.

At the same clock cycle, the twin set decoder **36** starts decoding the two short intermediate codes. Meanwhile, block **392** determines the a₀b₁ and a₀b₂ distances for the first next intermediate code, and a₁b₁ and a₁b₂ distances for the second next intermediate code for all the possibilities of the current codes. Depending on the occurring possibility of the current codes, two of the relative distances will be selected, one for the first next intermediate code and one for the second next intermediate code. Latch **430** stores the two selections for the next cycle.

After the two intermediate codes are decoded, at the same clock cycle, the adder **274** determines the total length of the decompressed data for the current cycle, ΔA **46**. Then the adder sends the ΔA **46** to block **390**. As described previously, block **390** updates the previous line decompressed data by ΔA to be used on the next clock cycle, and stores the updated previous line decompressed data in latch **386**.

Output block **54** receives the decompressed data of a long intermediate code or two short intermediate codes *via* lines **42**, **43**, **44** and **45**. If the intermediate code which generated the decompressed data was a long intermediate code or a short intermediate code which generated more than one bit data, then the output block 54 receives data only for one code *via* ALCNT **45** and ALDATA **43**. In this case, the output block sends out only one decompressed data on a 16-bit bus **56**, along with a CNT (count) **58** indicating the number of valid data bits on the data bus.

The output block 54 receives the decompressed data of the first and second short intermediate codes *via* ALDATA **43**, ALCNT **45**, BDATA **42** and BCNT **44** respectively, only when the first short intermediate code generates one bit decompressed data. The output block **54** places the decompressed data of the first and second short intermediate codes back-to-back and sends out the data on a 16-bit bus **56**. CNT (count) line **58** indicates how many bits on the data bus are valid data bits. In other words, CNT line **58** sends out the total length of the decompressed data.

The described embodiment works for both CCITT one-dimensinal and two-dimensional compression algorithms.

## Claims

1. Apparatus for decoding compressed image data, comprising:
means (18) for receiving and separating the compressed data image into short and long codes;
short channel decoding means (25) connected to the separating means for receiving the short codes therefrom and for generating decompressed data;
said short channel decoding means includes means (26) for receiving a first short code and a second short code from the separating means, and means (36) for generating in parallel a first decompressed data from the first short code and a second decompressed data from the second short code; and
long channel decoding means (28) connected to the separating means for receiving the long codes therefrom and for generating decompressed data.

2. The apparatus as claimed in claim **1**, wherein the short codes can generate a first minimum number of bits of decompressed data, and the long codes can generate a second minimum number of bits of decompressed data, the second minimum number of bits being greater than the first minimum number of bits.

3. The apparatus as claimed in claim 2, wherein the first minimum number of bits is one bit, and the second minimum number of bits is four bits.

4. The apparatus as claimed in any of claims 1 to 3, further comprising means for merging the first and the second decompressed data into a single output path.

5. The apparatus as claimed in any of claims 1 to 4, further comprising means for determining if the first decompressed data has a given number of bits; and means responsive to the determining means to output only the first decompressed data if the first decompressed data has more than the given minimum number of bits, and to output the first and the second decompressed data if the first decompressed data has only the given minimum number of bits.

6. A method for decoding compressed image data, comprising:
a) separating the codes into short and long codes;
b) generating either a first decompressed data from a first short code or generating in parallel the first decompressed data from the first short code, and a second decompressed data from a second short code, depending on the length of the first decompressed data; and
c) generating decompressed data from the long codes.

7. The method as claimed in claim 6, wherein the short codes can generate a first minimum number of bits of decompressed data, the long codes can generate a second minimum number of bits of decompressed data, the second minimum number of bits being greater than the first minimum number of bits, and wherein the step of separating the codes into short and long codes is in accordance with the minimum number of bits that can be generated by the codes.

8. The method as claimed in claim 7, wherein the first minimum number of bits is one bit, and the second minimum number of bits is four bits.

## Patentansprüche

1. Vorrichtung zum Decodieren verdichteter Bilddaten, umfassend:
eine Einrichtung (18) zum Empfangen und Trennen des verdichteten Datenbildes in kurze und lange Code;
eine Kurzkanal-Decodiereinrichtung (25), die mit der Trenneinrichtung zum Empfangen der kurzen Code von ihr und zum Erzeugen einer expandierten Date verbunden ist;
die genannte Kurzkanal-Decodiereinrichtung enthält eine Einrichtung (26) zum Empfangen eines ersten, kurzen Codes und eines zweiten, kurzen Codes von der Trenneinrichtung und eine Einrichtung (36) zum parallelen Erzeugen einer ersten, expandierten Date von dem ersten, kurzen Code und einer zweiten, expandierten Date von dem zweiten, kurzen Code; und
eine Langkanal-Codiereinrichtung (28), die mit der Trenneinrichtung zum Empfangen der langen Code von ihr und zum Erzeugen einer expandierten Date verbunden ist.

2. Die Vorrichtung, wie in Anspruch 1 beansprucht, worin die kurzen Code, eine erste, minimale Anzahl Bits expandierter Date erzeugen können, und die langen Code eine zweite, minimale Anzahl Bits expandierter Date erzeugen können, wobei die zweite, minimale Anzahl an Bits größer als die erste, minimale Anzahl an Bits ist.

3. Die Vorrichtung, wie in Anspruch 2 beansprucht, worin die erste, minimale Anzahl an Bits ein Bit ist und die zweite, minimale Anzahl an Bits vier Bits ist.

4. Die Vorrichtung, wie in irgendeinem der Ansprüche 1 bis 3 beansprucht, die ferner eine Einrichtung zum Vereinen der ersten und der zweiten, expandierten Date zu einem einzigen Ausgangsweg umfaßt.

5. Die Vorrichtung, wie in irgendeinem der Ansprüche 1 bis 4 beansprucht, die ferner eine Einrichtung zum Bestimmen umfaßt, ob die erste, expandierte Date eine gegebene Anzahl von Bits hat; und eine Einrichtung, die auf die Bestimmungseinrichtung reagiert, um nur die erste, expandierte Date auszugeben, wenn die erste, expandierte Date mehr als die gegebene minimale Anzahl an Bits hat, und die erste und die zweite, expandierte Date auszugeben, wenn die erste, expandierte Date nur die gegebene Anzahl an Bits hat.

6. Ein Verfahren zum Decodieren verdichteter Bilddaten, umfassend:
a) Trennen der Code in kurze und lange Code;
b) Erzeugen von entweder einer ersten, expandierten Date von einem ersten kurzen Code oder paralleles Erzeugen der ersten, expandierten Date von dem ersten, kurzen Code und einer zweiten, expandierten Date von einem zweiten, kurzen Code in Abhängigkeit von der Länge der ersten, expandierten Date, und
c) Erzeugen expandierter Daten von den langen Coden.

7. Das Verfahren, wie in Anspruch 6 beansprucht, worin die kurzen Code eine erste, minimale Anzahl an Bits expandierter Date erzeugen können, die langen Code eine zweite, minimale Anzahl an Bits expandierter Daten erzeugen können, die zweite, minimale Anzahl Bits größer als die erste, minimale Anzahl Bits ist, und worin der Schritt, die Code in kurze und lange Code zu trennen, nach Maßgabe der minimalen Anzahl Bits ist, die von den Coden erzeugt werden können.

8. Das Verfahren, wie in Anspruch 7 beansprucht, worin die erste minimale Anzahl an Bits ein Bit ist und die zweite, minimale Anzahl an Bits vier Bits ist.

## Revendications

1. Dispositif destiné à décoder des données d'image compressées, comprenant :
un moyen (18) destiné à recevoir et à séparer l'image en données compressées en codes courts et longs,
un moyen de décodage de canal court (25), relié au moyen de séparation, destiné à recevoir les codes courts provenant de celui-ci et à générer des données décompressées,
ledit moyen de décodage de canal court comprenant un moyen (26) destiné à recevoir un premier code court et un second code court provenant du moyen de séparation, et un moyen (36) destiné à générer en parallèle des premières données décompressées provenant du premier code court et des secondes données décompressées provenant du second code court, et
un moyen de décodage de canal long (28) relié au moyen de séparation afin de recevoir les codes longs provenant de celui-ci et de générer des données décompressées.

2. Dispositif selon la revendication 1, dans lequel les codes courts peuvent générer un premier nombre minimum de bits de données décompressées, et les codes longs peuvent générer un second nombre minimum de bits de données décompressées, le second nombre minimum de bits étant supérieur au premier nombre minimum de bits.

3. Dispositif selon la revendication 2, dans lequel le premier nombre minimum de bits est de un bit, et le second nombre minimum de bits est de quatre bits.

4. Dispositif selon l'une quelconque des revendications 1 à 3, comprenant en outre un moyen destiné à fusionner les premières et les secondes données décompressées sur une seule voie de sortie.

5. Dispositif selon l'une quelconque des revendications 1 à 4, comprenant en outre un moyen destiné à déterminer si les premières données décompressées présentent un nombre donné de bits, et un moyen répondant au moyen de détermination afin de sortir les premières données décompressées uniquement si les premières données décompressées présentent plus que le nombre minimum donné de bits, et de sortir les premières et les secondes données décompressées si les premières données décompressées ne présentent que le nombre minimum donné de bits.

6. Procédé destiné à décoder des données d'image compressées, comprenant les étapes consistant à :
a) séparer les codes en codes courts et longs,
b) soit générer des premières données décompressées provenant d'un premier code court, soit générer en parallèle les premières données décompressées provenant du premier code court, et des secondes données décompressées provenant d'un second code court, suivant la longueur des premières données décompressées, et
c) générer des données décompressées à partir des codes longs.

7. Procédé selon la revendication 6, dans lequel les codes courts peuvent générer un premier nombre minimum de bits de données décompressées, les codes longs peuvent générer un second nombre minimum de bits de données décompressées, le second nombre minimum de bits étant supérieur au premier nombre minimum de bits, et dans lequel l'étape consistant à séparer les codes en codes courts et longs se fait selon le nombre minimum de bits qui peuvent être générés par les codes.

8. Procédé selon la revendication 7, dans lequel le premier nombre minimum de bits est de un bit, et le second nombre minimum de bits est de quatre bits.
